Europäisches Patentamt

European Patent Office

Office européen des brevets

(11) Publication number: **0 094 200**
**B1**

(12) **EUROPEAN PATENT SPECIFICATION**

(45) Date of publication of patent specification: **06.08.86**

(51) Int. Cl.⁴: **H 01 L 23/36**

(21) Application number: **83302520.8**

(22) Date of filing: **05.05.83**

(54) Low-stress-inducing omnidirectional heat sink.

(30) Priority: **05.05.82 US 375069**

(43) Date of publication of application:
**16.11.83 Bulletin 83/46**

(45) Publication of the grant of the patent:
**06.08.86 Bulletin 86/32**

(84) Designated Contracting States:
**BE DE FR GB NL SE**

(56) References cited:
**DD-A- 79 783**
**US-A-3 212 569**
**US-A-3 213 324**

(73) Proprietor: **BURROUGHS CORPORATION (a
Michigan corporation)**
**Burroughs Place**
**Detroit, Michigan 48232 (US)**

(72) Inventor: **Lewis, Terrence Evan**
**4636 Cobb Drive**
**San Diego CA 92117 (US)**
Inventor: **Smiley, Stephen Alan**
**10945 Autillo Way**
**San Diego CA 92127 (US)**
Inventor: **Rice, Rex**
**1011 Sierra Drive**
**Menlo Park CA 94025 (US)**

(74) Representative: **Kirby, Harold Douglas Benson
et al**
**G.F. Redfern & Company Marlborough Lodge 14
Farncombe Road**
**Worthing West Sussex BN11 2BT (GB)**

Courier Press, Leamington Spa, England.

## Description

### Background of the invention

This invention relates to the art of packaging and cooling integrated circuits.

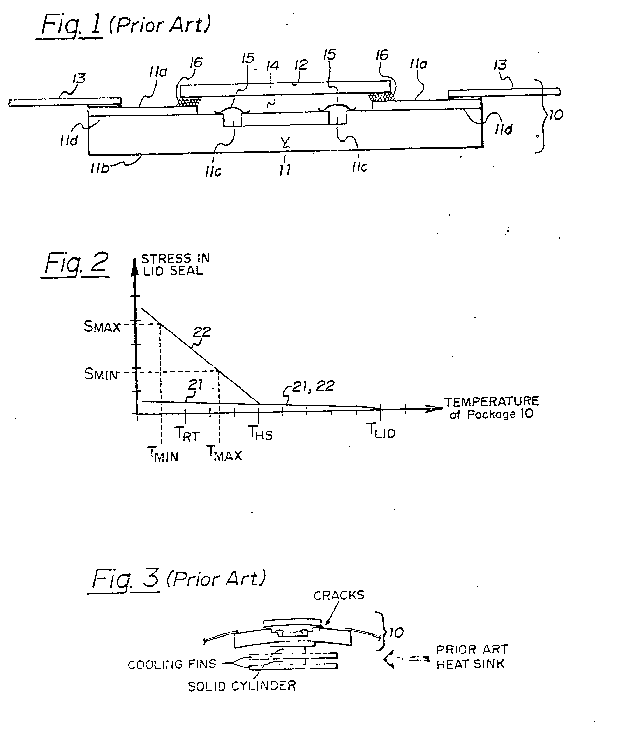

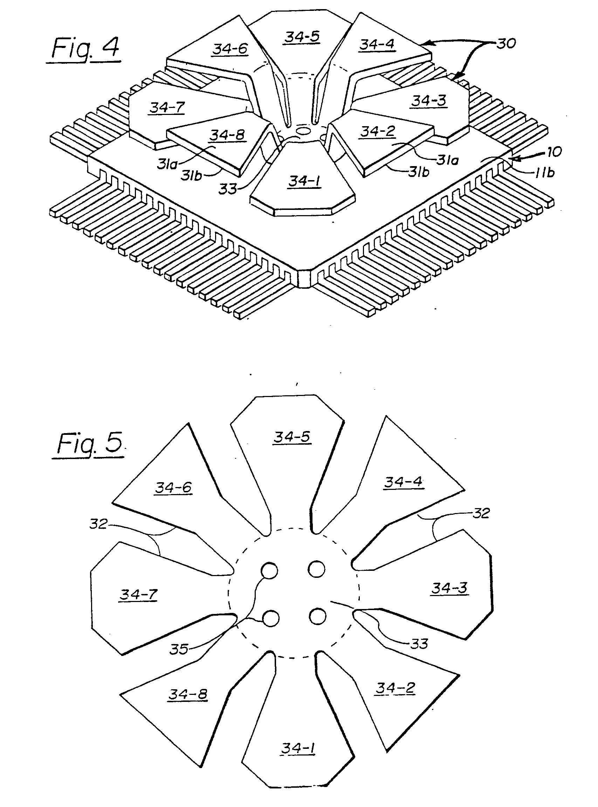

One commonly used integrated circuit package of the prior art is illustrated in cross section in Figure 1 where it is identified by reference numeral 10. Some of the major components of this package 10 are a substrate 11, a lid 12, a plurality of conductive leads 13, and an integrated circuit chip 14.

As Figure 1 shows, substrate 11 is rectangular in cross section. Also, it has a top major surface 11a and a bottom major surface 11b. Surface 11a has a cavity near its center which is shaped to receive chip 14. Surface 11b, by comparison, is merely flat.

A plurality of electrical conductors 11d lie within substrate 11 between the periphery of cavity 11c and the periphery of surface 11a. At the periphery of cavity 11c, electrical connections are made between the conductors 11d and chip 14 by a plurality of bonding wires 15. At the periphery of surface 11a, the conductors 11d contact the leads 13 directly which in turn extend from surface 11a to make electrical connections to an external system (not shown).

Lid 12 overlies cavity 11c and is rigidly attached to surface 11a at the periphery of the cavity by a lid attach material 16. This lid attach material 16 together with lid 12 and substrate 11 thus provide a hermetic enclosure for chip 14.

One specific example of the materials and their dimensions in the above-described circuit package is as follows: Substrate 11 is made of ceramic; and it has a length of 2.413 cm (0.950 inches), a width of 2.413 cm (0.950 inches) and a height of 0.152 cm (0.060 inches). Chip 14 is made primarily of silicon; and it has a length of 0.762 cm (0.300 inches), a width of 0.762 cm (0.300 inches), and a thickness of 0.051 cm (0.020 inches). Lid 12 is made of ceramic; and it has a length of 1.473 cm (0.580 inches), a width of 1.473 cm (0.580 inches), and a thickness of 0.076 cm (0.030 inches). And the lid attach material 16 is made of a layer of glass having a thickness of 0.005 cm (0.002 inches).

When chip 14 in package 10 is of the type that uses a relatively small amount of power (e.g., less than one watt), then no heat sink needs to be attached to the package. However, as the amount of power which chip 14 uses increases, a point is eventually reached at which a heat sink must be attached to the package in order to insure that chip 14 does not overheat.

Conventionally, the heat sink is made of metal, such as copper or aluminum; and it is rigidly attached by an epoxy or a solder to surface 11b directly below chip 14. During the attachment process, the epoxy or solder is heated to a fluid state whereupon it is dispersed in a thin smooth layer between surface 11b and the heat sink. Thereafter, the epoxy or solder is allowed to cool and harden.

However, this cooling and hardening step also induces stresses in the package, and particularly in the lid attach material 16. These stresses vary in magnitude with the overall shape of the particular heat sink that is being attached. And, depending on the shape of the heat sink, the stresses can become so large as to cause cracks in the lid attach material 16. When this occurs, the hermetic seal for chip 14 is broken which makes the package inoperable.

To further understand how the heat sink induces stresses in the lid attach material 16, reference should now be made to Figure 1. That Figure contains a graph wherein the temperature of the integrated circuit package is plotted on a horizontal axis, and stress in the lid attach material 16 is plotted on a vertical axis. In this graph, a curve 21 illustrates how stress in the lid attach material 16 varies as a function of temperature under the condition where no heat sink is attached to package 10; while another curve 22 shows how stress in the lid attach material 16 varies under the conditions where a heat sink is attached to package 10.

Curves 21 and 22 begin at a temperature $T_{LID}$, which is the temperature at which the lid attach material solidifies. For example, temperature $T_{LID}$ is approximately 320°C when the lid attach material is glass. In order to attach lid 12 to surface 11a, the lid attach material must be heated above temperature $T_{LID}$, and typically it is heated to 420°C. Thereafter, the package is cooled to room temperature $T_{RT}$.

During this cooling, both substrate 11 and lid 12 contract. But this contraction induces only relatively small stresses in the attach material 16, because both lid 12 and substrate 11 are made of essentially the same material and thus they contract at nearly equal rates.

Thereafter, package 10 is reheated to attach the heat sink to surface 11b. In this step, the temperature to which the package is heated must exceed the solidification temperature $T_{HS}$ of the heat sink attach material. For example, the temperature for solder is about 183°C, and for an epoxy is about 150°C.

So long as the heat sink attach material remains liquid, the stresses induced in the lid attach material 16 remain relatively small. However, once the heat sink attach material solidifies at temperature $T_{HS}$, the stresses in the lid attach material 16 rapidly increase. This rapid increase in stress is due to the fact that the heat sink contracts much more rapidly than the ceramic substrate. For example, the coefficients of thermal expansion for copper and aluminum respectively are about 2.6 and 3.6 times the expansion coefficient of ceramic.

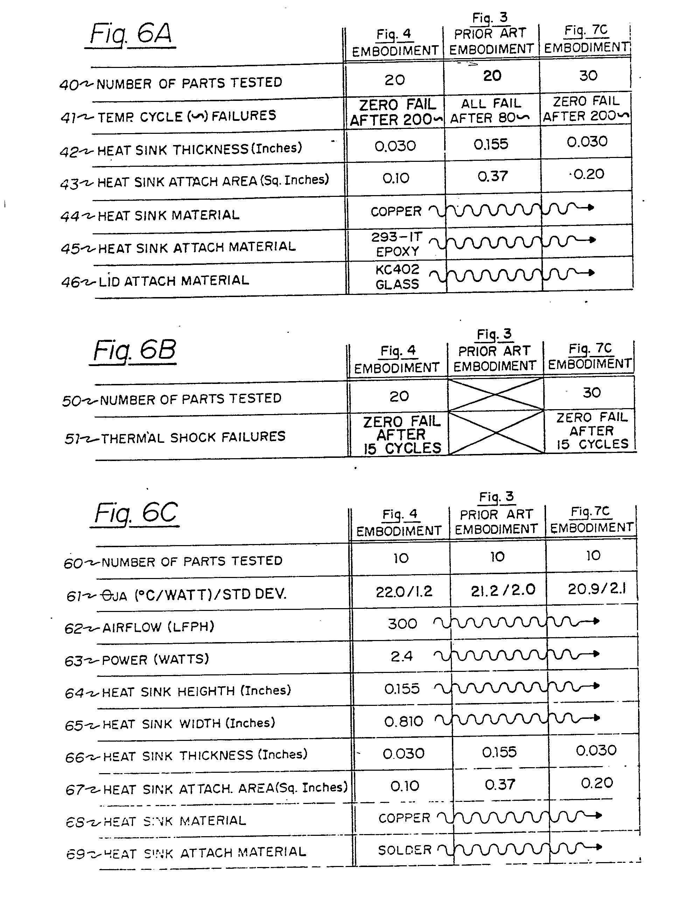

As the heat sink contracts, it tends to compress that portion of surface 11b to which the heat sink is attached. This in turn causes substrate 11 to bend in an arc-shaped fashion as illustrated in Figure 3. In this Figure, the amount of bending is greatly exaggerated merely to illustrate the point that such bending actually does occur. This bending, in turn, causes the rapid increase in stress in the lid attach material 16.

After the heat sink is attached and the integrated circuit package is placed in an operating environment, the package is subjected to some predetermined range of operating temperatures. A typical maximum operating temperature, for example, is 125°C; and a typical minimum operating temperature is −55°C. Such maximum and minimum operating temperatures are indicated in Figure 2 as $T_{max}$ and $T_{min}$ respectively.

Curve 22 shows that at temperature $T_{max}$, the stress in lid attach material 16 is at a minimal level $S_{min}$; whereas at temperature $T_{min}$, the stress in lid attach material 16 is at a maximum level $S_{max}$. So in the operating environment, stress in the lid attach material varies between $S_{max}$ and $S_{min}$. And the magnitude of the maximum stress $S_{max}$ as well as any cycling between $S_{max}$ and $S_{min}$ frequently cause lid attach material to crack.

In US—A—3 212 569 there is disclosed a heat sink for cooling individual transistors. This heat sink has a planar bottom portion which includes three holes. The transistor lies on the bottom portion such that the transistor leads pass through the holes. A plurality of fingers extend upwardly from the bottom portion in a direction opposite to the direction of the transistor leads so that the transistor is enclosed within the fingers. With this design the area of the bottom portion of the heat sink is forced to be larger than the area of the transistor that is being cooled.

In DD—A—79783 there is disclosed a heat sink for an integrated circuit package having a cup-shaped housing. The heat sink embraces the cup-shaped housing, and a plurality of fingers extend radially from the housing. The problem of cracking referred to above is not relevant to this type of housing and heat sink.

The present invention is concerned with an integrated circuit package in combination with a heat sink, wherein said integrated circuit package has a first planar surface and a second planar surface to which a lid is bonded by means of lid-attach material, wherein said heat sink is formed of a single thin sheet of heat conducting material having first and second oppositely facing major surfaces, and having a planar central portion and a plurality of spaced-apart finger-shaped portions formed to extend out of the plane of said central portion, and wherein the second surface of said central portion is bonded to said first planar surface of said integrated circuit package. The present invention consists in that the area of said central portion is less than that of said first planar surface, in that said finger-shaped portions extend from said central portion so that the ends thereof are radially displaced with respect to said control portion as well as being out of the plane thereof and in that said finger-shaped portions are located on the same side of said central portion as said second major surface.

Surprisingly it has been found that the integrated circuit package prevents the cracking of the package which occurred in the prior art devices described above.

Brief description of the drawings

Various features and advantages of the invention are described in the Detailed Description in conjunction with the accompanying drawings wherein:

Figure 1 is an enlarged cross-sectional view of a prior art integrated circuit package that is suitable for use with a heat sink of the present invention;

Figure 2 is a graph illustrating the manner in which a heat sink of the prior art induces stress in the lid attach material of the Figure 1 integrated circuit package;

Figure 3 is a schematic diagram illustrating how a heat sink of the prior art bends the Figure 1 integrated circuit package;

Figure 4 is a pictorial view of one preferred embodiment of a heat sink constructed according to the invention;

Figure 5 is a planar view of the heat sink of Figure 4 at an intermediate stage of its fabrication;

Figures 6A—6C are a set of tables containing test data showing some of the superior features of the present invention over the prior art; and

Figures 7A—7D are pictorial views of additional preferred embodiments of the present invention.

Detailed description of the invention

Referring now to Figures 4 and 5, one preferred embodiment of the invention will be described in detail. This particular embodiment is identified in Figures 4 and 5 by reference numeral 30. Figure 4 illustrates heat sink 30 in a pictorial view which also shows the heat sink attached to surface 11b of the integrated circuit package 10 of Figure 1. Figure 5, by comparison, is a planar view of the heat sink 30 at an intermediate stage of its fabrication process.

Heat sink 30 consists of a single thin sheet of material having two oppositely facing major surfaces 31a and 31b. Surfaces 31a and 31b have a common perimeter 32. That perimeter 32 defines a plurality of spaced-apart finger-shaped portions 34 of the heat sink that extend radially from a central portion 33.

In the illustrated preferred embodiment of Figures 4 and 5, there are eight finger-shaped portions 34-1 through 34-8; and they are equally spaced around the central portion. As an alternative, however, the number of finger-shaped portions can be other than eight and preferably it is in the range of four to 18.

Heat sink 30 is fabricated from a single thin flat sheet of material that is rectangular-shaped. That rectangular-shaped material is stamped with a cutting tool having the above-described perimeter 32. Figure 5 shows the flat sheet of material after this stamping step.

Thereafter, all of the finger-shaped portions are formed into a cylindrical shape such that the central portion 33 is at one end of the cylinder;

and, the extremities of the finger-shaped portions are formed outward in a fan-like manner so as to reside in one or more planes parallel with the central portion 33. Suitably, these steps are performed by forming two bends of 60°—90° in each finger-shaped portion. Due to these bends, the finger-shaped portions 34-1 through 34-8 form cooling fins for the central portion 33. This is illustrated in Figure 4.

Preferably, the distance between the two bends in adjacent finger-shaped portions varies in a cyclic fashion around the central portion 33. In other words, preferably the height of the open ends of the cooling fins alternates in a cyclic fashion around the central portion. This variance in height produces a turbulence in any airflow that passes through the cooling fins which enhances the heat sink's cooling capability.

Also preferably, a plurality of holes 34 are included in the central portion. These holes enhance the strength of the bond between the heat sink and package to which the heat sink is attached. In particular, the holes provide a means whereby any gas can escape from between the heat sink attach material and the integrated circuit package attach surface, and thus reduce voids in the heat sink attach material. Also, the holes provide a means for the heat sink attach material to seep through the central portion and bond to surface 31a around the holes' perimeter.

One specific example of the materials and dimensions in the above-described embodiment of the invention is as follows. Heat sink 30 is formed of a sheet of metal, such as copper or aluminum, which is 0.038 cm (0.015 inches)—0.114 cm (0.045 inches) thick. From such a sheet, the heat sink is stamped with the perimeter Figure 5. Suitably, the radius for the central portion is 0.508 cm (0.200 inches); the distance between the bends of fins 34-1, 34-3, 34-5, and 34-7 is 0.152 cm (0.060 inches) while the remaining length of those fins is 0.559 cm (0.220 inches); the distance between the bends of fins 34-2, 34-4, 34-6, and 34-8 is 0.381 cm (0.150 inches) while the remaining length of those fins is 0.330 cm (0.130 inches); and the holes 35 are equally spaced and have a radius of 0.051 cm (0.020 inches).

Reference should now be made to Figures 6A, 6B, and 6C wherein various test results for the above-described heat sink of Figures 4 and 5 are given in three tables. These tables also contain other test results, for comparison purposes, for a heat sink of the prior art. Figure 6A gives the results from a temperature-cycling test; Figure 6B gives the results from a thermal shock test; and Figure 6C gives the results from a cooling test.

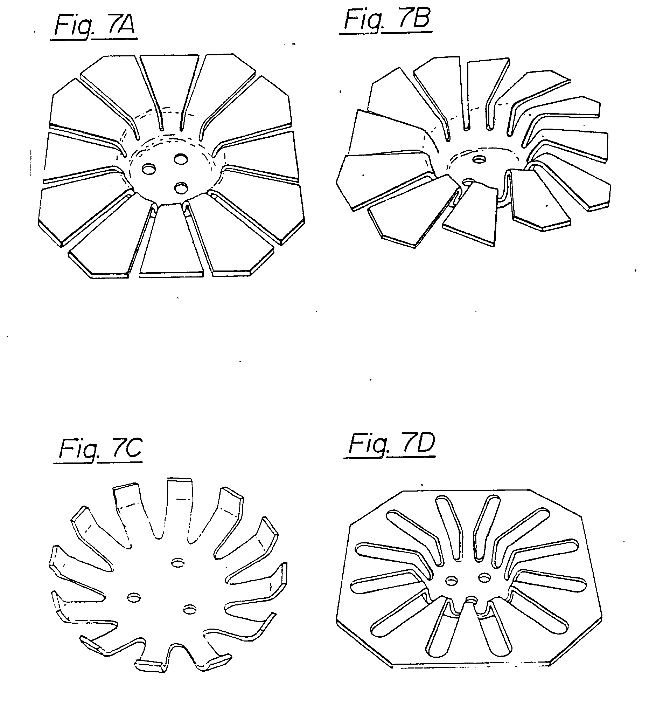

Considering first the table of Figure 6A, that table has seven rows 40—46, and three columns. The columns identify the heat sink under test as the "Fig. 4 Embodiment", "Fig. 3 Prior Art Embodiment", and "Fig. 7C Embodiment", whereas the rows list various test data. In the discussion that immediately follows, the Fig. 4 embodiment is compared to the prior art. Thereafter, the Fig. 7 embodiment (which is another embodiment of the invention) is compared to the prior art.

In performing the temperature-cycling test of Figure 6A, 20 heat sinks of the Figure 4 type were attached to respective integrated circuit packages of the Figure 1 type; and 20 prior art heat sinks of the Figure 3 type were attached to identical integrated circuit packages. That prior art heat sink of Figure 3, as made and sold by Thermalloy, Inc., was chosen because it has the very attractive feature of cooling with an omnidirectional air flow. Rows 42—46 in Figure 6 list all of the physical parameters for the Figure 4 heat sink and Figure 3 heat sink which are relevant to the temperature-cycling test.

To conduct the temperature-cycling test, two separate chambers are provided. One of the chambers is filled with air at a temperature of 125°C; and the other chamber is filled with air at −55°C. The integrated circuit packages with their attached heat sinks are moved in cyclic fashion between these two chambers; 15 minutes is spent in one chamber before the IC packages with their attached heat sinks are moved to the next chamber.

Inspection of row 41 shows that after 200 cycles, none of the 20 heat sinks of Figure 4 caused any cracks in integrated circuit packages to which they were attached. By comparison, after only 80 cycles, all 20 of the prior art heat sinks of Figure 3 caused cracks in the lid attach material of the packages to which they were attached.

To detect the presence or absence of a crack in the lid attach material, the tested parts are immersed in a radioactive gas. If cracks exist, some of the radioactive gas gets trapped in cavity 11c. Thereafter, the parts are removed from the gas and the presence or absence of any trapped particles is detected by a Geiger counter. Thus, the above tests are extremely accurate.

Next, consider the results of the thermal shock test in the table of Figure 6B. In that table, the columns again identify the heat sinks under test, and the rows again identify particular test data. Note that all of the physical parameters of the heat sinks that were tested in the Figure 6B thermal shock test are the same as those listed in rows 42—46 in Figure 6A for the temperature cycle test.

To conduct the thermal shock test, two chambers are again provided; but this time they are filled with a liquid. In one of the chambers, the liquid is at a temperature of 125°C; and in the other chamber, the liquid is at a temperature of −55°C. Again, the integrated circuit packages with their attached heat sinks are moved from chamber to chamber in a cyclic fashion. Five minutes is spent in one chamber, then five minutes is spent in another chamber, etc.

Row 50 in Figure 6B shows that 20 heat sinks of the Figure 4 embodiment were subjected to the thermal shock test. These heat sinks were again attached to the integrated circuit package of the Figure 1 type. Row 51 shows that after 15 cycles, none of the Figure 4 type heat sinks caused any cracks in the lids of the integrated circuit packages to which they were attached.

This thermal shock test is a more severe test than the above-described temperature-cycling test. Thus, none of the Figure 3 type heat sinks were subjected to the thermal shock test since they could not even pass the temperature-cycling test.

Next, consider the results of the cooling test that are given in the table of Figure 6C. Again in that table, the particular heat sinks that were tested are identified in the columns; and various test data is given in the rows 60—69.

Rows 64 and 65 show that the heat sinks under test have the same overall height and overall width. This is needed to make a fair comparison, since a heat sink's cooling ability generally increases as its size increases. Also, note that rows 68 and 69 show that the heat sinks under test were made of the same material, and were attached to their IC package via the same attach material.

Ten heat sinks of the Figure 4 type were tested along with ten heat sinks of the Figure 3 prior art type. Row 61 gives the average thermal resistance for all ten tested heat sinks of the same type, along with corresponding standard deviations from the average resistance. Inspection of row 61 shows that the average thermal resistance of the Figure 4 type heat sink is within 0.8°C/W of the average thermal resistance of the Figure 3 prior art type heat sink, and that the Figure 4 heat sink has a smaller standard deviation. This means that both heat sinks have substantially the same cooling ability.

In summary then, the test results of Figures 6A, 6B, and 6C show the superiority of the Figure 4 type heat sink in terms of its tendency to greatly reduce thermally induced stress in an integrated circuit package without sacrificing cooling ability. Also, the heat sink of Figure 4 cools in an omnidirectional fashion; and this, of course, is important because it enables the integrated circuit packages to which the heat sinks are attached to be oriented in several different directions on a printed circuit board without impeding their cooling. Further, the heat sink of Figure 4 is simple to manufacture as was explained in conjunction with Figure 5. Those manufacturing steps merely include a stamping and bending operation; whereas by comparison, the prior art heat sink of Figure 3 must be cut from rotating stock on a screw machine.

Turning now to Figures 7A—7D, various alternate preferred embodiments of the invention will be described. Beginning with Figure 7A, the embodiment there illustrated is similar to the previously described embodiment of Figure 4 in that it also is made of a single thin sheet of material having a common perimeter that defines a plurality of finger-shaped portions around a central portion. However, the Figure 7A embodiment has a total of 12 finger-shaped portions (as opposed to eight finger-shaped portions in the Figure 4 embodiment). Also, all of the finger-shaped portions in the Figure 7A embodiment are bent such that their open ends lie at the same height above the central portion.

Next, consider the embodiment of Figure 7B. It also is similar to the previously described embodiment of Figure 4. However, it differs from the Figure 4 embodiment in that the open ends of the finger-shaped portions are all twisted on their axis at a predetermined angle. Preferably, this angle is in the range of 0—45°. These twisted open ends of the finger-shaped portions cause a turbulence in the air that passes through them which in turn enhances the heat sink's cooling action.

Consider next the embodiment of Figure 7C. It differs from the Figure 4 embodiment in that it has a total of 12 finger-shaped portions around the central portion; and in addition, the finger-shaped portions are bent in an arc-shaped fashion out of the plane of the central portion.

Finally, the Figure 7D embodiment differs from the Figure 4 embodiment in that the common perimeter of the heat sink does not define any central portion or finger-shaped portions at all. Instead, the Figure 7D embodiment has a plurality of radially-oriented elongated slots each of which have a pair of end-walls at two predetermined distances from a point that is centrally located within the common perimeter. Those end-walls nearest the central point define the central portion of the heat sink; while those end-walls furthest from the central point together with the common perimeter define a ring-shaped portion around the central portion. Also, the side-walls of the slots which join the end-walls define a plurality of finger-shaped portions that connect the central portion to the ring-shaped portion. The central portion is flat and attaches to the integrated circuit package; whereas the fingers are bent out of the plane of the central portion, and together with the ring-shaped portion they provide a means for cooling the central portion.

All of the above-described Figure 7A—7D embodiments are made by providing a thin rectangular-shaped sheet of material; stamping the heat sink from that sheet with a cutting tool having a perimeter the desired heat sink shape; and bending the stamped part in the manner illustrated in Figures 7A—7D.

Test results for the Figure 7C embodiment are contained in the tables of Figures 6A, 6B, and 6C. Row 41 of Figure 6A shows that 30 of the Figure 7C type heat sinks were temperature cycled 200 times; and none of them caused any cracks in the IC package. Row 51 of Figure 6B shows that 30 of the Figure 7B type heat sinks were subjected to 15 thermal shock cycles; and again, none of them caused cracks in the IC package. Row 60 of Figure 6C shows that ten of the Figure 7C type heat sinks were tested for their thermal cooling ability; and they had an average thermal resistance which was lower than the prior art heat sink of Figure 3.

**Claims**

1. An integrated circuit package in combination with a heat sink, wherein said integrated circuit package has a first planar surface (11b) and a second planar surface (11a) to which a lid (12) is bonded by means of lid-attach material (16), wherein said heat sink is formed of a single thin sheet of heat conducting material having first and second oppositely facing major surfaces (31a and 31b), and having a planar central portion and a plurality of spaced-apart finger-shaped portions (34) formed to extend out of the plane of said central portion (33), and wherein the first surface (31b) of said central portion (33) is bonded to said first planar surface (11b) of said integrated circuit package, characterised in that the area of said central portion (33) is less than that of said first planar surface (11b), in that said finger-shaped portions (34) extend from said central portion so that the ends thereof are radially displaced with respect to said central portion as well as being out of the plane thereof and in that said finger-shaped portions (34) are located on the same side of said central portion as said second major surface (31a).

2. A combination according to Claim 1, characterised in that the width of said finger-shaped portions increases as they extend radially outwardly and in that the outermost parts of said finger-shaped portions merge to form a ring-shaped portion around said central portion (Figure 7D).

3. A combination according to Claims 1 or 2 wherein said finger-shaped portions bend out of said plane at an angle of 60—90 degrees and thereafter bend in an opposite direction at an angle of 60—90 degrees to lie parallel to said plane.

4. A combination according to Claims 1 or 2 wherein said finger-shaped portions bend out of said plane in a gradual, arc-like fashion.

5. A combination according to Claims 1 or 2 wherein the ends of all of said finger-shaped portions lie at the same level above said plane.

6. A combination according to Claims 1 or 2 wherein the ends of said finger-shaped portions cyclically vary at relatively high and relatively low levels above said plane.

7. A combination according to Claims 1 or 2 wherein said central portion is circular-shaped.

8. A combination according to Claims 1 or 2 wherein said central portion has a plurality of spaced-apart holes whose total area is substantially less than the total area of said central portion.

9. A combination according to Claim 1 wherein the said finger-shaped portions twist along their axis at a predetermined angle.

## Patentansprüche

1. Kombination eines Gehäuses für eine integrierte Schaltung und eines Kühlprofils, bei der das Gehäuse für die integrierte Schaltung eine erste ebene Fläche (11b) und eine zweite ebene Fläche (11a) aufweist, auf die ein Deckel (12) mittels eines Deckelbefestigungsmaterials (16) aufgeklebt ist, bei der das Kühlprofil aus einer einzigen dünnen Platte aus wärmeleitendem Material gebildet ist, die erste und zweite entgegengesetzt gerichtete Hauptflächen (31a und 31b), einen ebenen Mittenabschnitt und mehrere beabstandete fingerförmige Abschnitte (34) aufweist, die so gestaltet sind, daß sie sich aus der Ebene des Mittenabschnittes (33) erstrecken, und bei der ersten Fläche (31b) des Mittenabschnittes (33) mit der ersten ebenen Fläche (11b) des Gehäuses für die integrierte Schaltung verbunden ist, dadurch gekennzeichnet, daß die Fläche des Mittenabschnittes (33) kleiner als die der ersten ebenen Fläche (11b) ist, daß sich die fingerförmigen Abschnitte (34) von dem Mittenabschnitt so erstrecken, daß deren Enden sowohl radial in Bezug auf den Mittenabschnitt versetzt als auch außerhalb dessen Ebene liegen und daß die fingerförmigen Abschnitte (34) auf derselben Seite des Mittenabschnittes wie die zweite Hauptfläche (31a) angeordnet sind.

2. Kombination nach Anspruch 1, dadurch gekennzeichnet, daß die Breite der fingerförmigen Abschnitte mit deren radialer Erstreckung nach außen anwächst und daß die äußersten Teile der fingerförmigen Abschnitte zusammenlaufen und einen ringförmigen Abschnitt um den Mittenabschnitt bilden (Figur 7D).

3. Kombination nach Anspruch 1 oder 2, dadurch gekennzeichnet, daß die fingerförmigen Abschnitte in einem Winkel von 60—90° und daran anschließend in entgegengesetzter Richtung unter einem Winkel von 60—90° abgebogen sind und somit parallel zur Ebene liegen.

4. Kombination nach Anspruch 1 oder 2, dadurch gekennzeichnet, daß die fingerförmigen Abschnitte aus der Ebene fortschreitend bogenförmig ausbiegen.

5. Kombination nach Anspruch 1 oder 2, dadurch gekennzeichnet, daß die Enden aller fingerförmigen Abschnitte auf derselben Höhe über der Ebene liegen.

6. Kombination nach Anspruch 1 oder 2, dadurch gekennzeichnet, daß die Enden der fingerförmigen Abschnitte zyklisch abwechselnd hoch und niedrig über der Ebene angeordnet sind.

7. Kombination nach Anspruch 1 oder 2, dadurch gekennzeichnet, daß der Mittenabschnitt kreisförmig ausgebildet ist.

8. Kombination nach Anspruch 1 oder 2, dadurch gekennzeichnet, daß der Mittenabschnitt mehrere beabstandete Löcher aufweist, deren Gesamtfläche wesentlich kleiner als die Gesamtfläche des Mittenabschnittes ist.

9. Kombination nach Anspruch 1, dadurch gekennzeichnet, daß die fingerförmigen Abschnitte entlang ihrer Achse um einen vorbestimmten Winkel verdreht sind.

## Revendications

1. Boîtier de circuit intégré combiné à un diffuseur de chaleur dans lequel un boîtier de circuit intégré comporte une première surface plane (11b) et une seconde surface plane (11a) à laquelle est fixé un couvercle (12) par l'intermédiaire d'un matériau de fixation de couvercle (16), le diffuseur de chaleur étant réalisé dans une seule feuille mince de matière conductrice de chaleur, il présente une première et une seconde surfaces principales, opposées (31a et 31b), et une partie centrale plane ainsi qu'un ensemble de parties en forme de doigts (34) espacées, réalisées de façon à être en saillie par rapport au plan de la partie centrale (33) et la première surface (31b) de la partie centrale (33) est collée à la première surface plane (11b) du boîtier de circuit intégré, caractérisé en ce que la surface de la partie centrale (33) est inférieure à celle de la première surface plane (11b), en ce que les parties en forme de doigts (34) sont en saillie par rapport à la partie centrale, de sorte que les extrémités sont décalées radialement par rapport à la partie central et sont en saillie par rapport au plan de celle-ci, et en ce que les parties en forme de doigts (34) se trouvent du même côté de la partie central que la seconde surface principale (31a).

2. Combinaison selon la revendication 1, caractérisée en ce que la largeur des parties en forme de doigts augmente en fonction de leur éloignement radial vers l'extérieur et en ce que les zones les plus à l'extérieur des parties en forme de doigts se rencontrent pour former une partie annulaire entourant la partie centrale (figure 7D).

3. Combinaison selon les revendications 1 ou 2, caractérisée en ce que les parties en forme de doigts qui sont pliées en saillie par rapport au plan suivant un angle de 60—90 degrés, puis sont pliées dans la direction opposée suivant un angle de 60—90 degrés pour être parallèles à ce plan.

4. Combinaison selon les revendications 1 ou 2, caractérisée en ce que les parties en forme de doigts sont pliées hors du plan de façon progressive en arc.

5. Combinaison selon les revendications 1 ou 2, caractérisée en ce que les extrémités de toutes les parties en forme de doigts se situent au même niveau au-dessus du plan.

6. Combinaison selon les revendications 1 ou 2, caractérisée en ce que les extrémités des parties en forme de doigts varient de façon cyclique à des niveaux relativement hauts et relativement bas au-dessus du plan.

7. Combinaison selon les revendications 1 ou 2, caractérisé en ce que la partie centrale est de forme circulaire.

8. Combinaison selon les revendications 1 ou 2, caractérisée en ce que la partie centrale comporte un ensemble d'orifices espacés et dont la surface totale est notablement inférieure à la surface totale de la partie centrale.

9. Combinaison selon la revendication 1, caractérisée en ce que les parties en forme de doigts sont tordues suivant leur axe et selon un angle prédéterminé.

Fig. 1 (Prior Art)

Fig. 2

Fig. 3 (Prior Art)

Fig. 4

34-6  34-5  34-4  30

34-7  34-3

34-8  34-2

31a  31a

31b  31b  10

33  34-1  11b

Fig. 5

34-5

34-6  34-4

32  32

34-7  34-3

35  33

34-8  34-2

34-1

## Fig. 6A

| | Fig. 4 EMBODIMENT | Fig. 3 PRIOR ART EMBODIMENT | Fig. 7C EMBODIMENT |
|---|---|---|---|
| 40〜 NUMBER OF PARTS TESTED | 20 | 20 | 30 |
| 41〜 TEMP. CYCLE (〜) FAILURES | ZERO FAIL AFTER 200〜 | ALL FAIL AFTER 80〜 | ZERO FAIL AFTER 200〜 |
| 42〜 HEAT SINK THICKNESS (Inches) | 0.030 | 0.155 | 0.030 |
| 43〜 HEAT SINK ATTACH AREA (Sq. Inches) | 0.10 | 0.37 | ·0.20 |
| 44〜 HEAT SINK MATERIAL | COPPER 〰〰〰〰〰→ | | |
| 45〜 HEAT SINK ATTACH MATERIAL | 293-IT EPOXY 〰〰〰→ | | |
| 46〜 LID ATTACH MATERIAL | KC402 GLASS 〰〰〰→ | | |

## Fig. 6B

| | Fig. 4 EMBODIMENT | Fig. 3 PRIOR ART EMBODIMENT | Fig. 7C EMBODIMENT |
|---|---|---|---|
| 50〜 NUMBER OF PARTS TESTED | 20 | ✕ | 30 |
| 51〜 THERMAL SHOCK FAILURES | ZERO FAIL AFTER 15 CYCLES | ✕ | ZERO FAIL AFTER 15 CYCLES |

## Fig. 6C

| | Fig. 4 EMBODIMENT | Fig. 3 PRIOR ART EMBODIMENT | Fig. 7C EMBODIMENT |
|---|---|---|---|
| 60〜 NUMBER OF PARTS TESTED | 10 | 10 | 10 |
| 61〜 $\Theta$JA (°C/WATT)/STD DEV. | 22.0/1.2 | 21.2/2.0 | 20.9/2.1 |
| 62〜 AIRFLOW (LFPH) | 300 〰〰〰〰→ | | |
| 63〜 POWER (WATTS) | 2.4 〰〰〰〰→ | | |
| 64〜 HEAT SINK HEIGHTH (Inches) | 0.155 〰〰〰〰→ | | |
| 65〜 HEAT SINK WIDTH (Inches) | 0.810 〰〰〰〰→ | | |
| 66〜 HEAT SINK THICKNESS (Inches) | 0.030 | 0.155 | 0.030 |
| 67〜 HEAT SINK ATTACH. AREA (Sq. Inches) | 0.10 | 0.37 | 0.20 |
| 68〜 HEAT SINK MATERIAL | COPPER 〰〰〰〰→ | | |
| 69〜 HEAT SINK ATTACH MATERIAL | SOLDER 〰〰〰〰→ | | |

0 094 200

Fig. 7A

Fig. 7B

Fig. 7C

Fig. 7D

4